(19) Europäisches Patentamt
European Patent Office
Office européen des brevets

(11) **EP 2 067 550 B1**

(12) **EUROPEAN PATENT SPECIFICATION**

(45) Date of publication and mention
of the grant of the patent:
**21.12.2016 Bulletin 2016/51**

(51) Int Cl.:
*B22F 1/00* (2006.01)    *B22F 9/24* (2006.01)
*H01B 1/22* (2006.01)    *H01B 5/00* (2006.01)
*H01B 5/14* (2006.01)    *H01B 13/00* (2006.01)
*H05K 1/09* (2006.01)    *H01L 51/00* (2006.01)

(21) Application number: **07807430.9**

(22) Date of filing: **11.09.2007**

(86) International application number:
**PCT/JP2007/068026**

(87) International publication number:
**WO 2008/038534 (03.04.2008 Gazette 2008/14)**

(54) **SILVER MICROPARTICLE POWDER AND METHOD FOR PRODUCTION THEREOF**

SILBERMIKROTEILCHENPULVER UND HERSTELLUNGSVERFAHREN DAFÜR

POUDRE DE MICROPARTICULES D'ARGENT ET SON PROCÉDÉ DE PRODUCTION

(84) Designated Contracting States:
**DE FR GB NL**

(30) Priority: **26.09.2006 JP 2006261526**

(43) Date of publication of application:
**10.06.2009 Bulletin 2009/24**

(73) Proprietor: **DOWA Electronics Materials Co., Ltd.**
**Chiyoda-ku**
**Tokyo 101-0021 (JP)**

(72) Inventors:
• **OGI, Kozo**
**Chiyoda-ku**
**Tokyo 101-0021 (JP)**
• **OKANO, Taku**
**Chiyoda-ku**
**Tokyo 101-0021 (JP)**

(74) Representative: **Wagner & Geyer**
**Partnerschaft**
**Patent- und Rechtsanwälte**
**Gewürzmühlstrasse 5**
**80538 München (DE)**

(56) References cited:
**EP-A2- 1 698 413       WO-A1-2006/082987**
**WO-A1-2006/082996    JP-A- 2001 214 201**
**JP-A- 2006 241 494      US-B1- 6 632 524**
**US-B1- 6 878 184**

• **HONGJIN JIANG ET AL: "Variable Frequency Microwave Synthesis of Silver Nanoparticles", JOURNAL OF NANOPARTICLE RESEARCH ; AN INTERDISCIPLINARY FORUM FOR NANOSCALE SCIENCE AND TECHNOLOGY, KLUWER ACADEMIC PUBLISHERS, DO, vol. 8, no. 1, 17 March 2006 (2006-03-17), pages 117-124, XP019404280, ISSN: 1572-896X**

• **ZHU Z ET AL: "Synthesis and applications of hyperbranched polyesters-preparation and characterization of crystalline silver nanoparticles", MATERIALS CHEMISTRY AND PHYSICS, ELSEVIER, vol. 96, no. 2-3, 10 April 2006 (2006-04-10), pages 447-453, XP024994892, ISSN: 0254-0584 [retrieved on 2006-04-10]**

• **JOARDAR J ET AL: "Estimation of entrapped powder temperature during mechanical alloying", SCRIPTA MATERIALIA, ELSEVIER, AMSTERDAM, NL, vol. 50, no. 9, 1 May 2004 (2004-05-01), pages 1199-1202, XP004492751, ISSN: 1359-6462, DOI: 10.1016/J.SCRIPTAMAT.2004.02.011**

EP 2 067 550 B1

**Description**

TECHNICAL FIELD

The present invention relates to a fine silver particle powder (especially having a nanometer-order particle size), more particularly, to such a silver particle powder and a silver particle powder dispersion favorably usable for a wiring forming material for forming a circuit micropattern, for example, for a wiring forming material for an inkjet method, for a film forming material substitutive for film formation by sputtering in a vacuum film formation process, and for a film forming material substitutive for film formation by plating in a wet process, or the like, and relates to a baked silver film obtained using the same.

BACKGROUND ART

When the size of a solid substance is on an nm order (nano-meter order), the specific surface area thereof is extremely large, and therefore, though it is solid, its interface with vapor or liquid is extremely large. Accordingly, its surface characteristics greatly control the properties of the solid substance. For a metal particle powder, it is known that the melting point of the powder dramatically lowers as compared with that as a bulk, and therefore, as compared with particles on a $\mu$m order, the powder has some advantages in that it enables micropatterning in wiring and it may be sintered at a low temperature. Of such a metal particle powder, a silver particle powder has low electric resistance and has high weather resistance, and the cost of the metal is lower than that of other noble metals, and therefore a silver particle powder is especially expected as a next-generation wiring material for micropatterning in wiring formation.

For forming electrodes and circuits for electric components and others, widely employed is a thick film paste method. A thick film paste is one prepared by dispersing a metal powder and, in addition to it, a glass frit, an inorganic oxide and the like in an organic vehicle. The paste is formed into a predetermined pattern by printing or dipping, and then heated at a temperature not lower than 500°C to remove the organic ingredient by firing thereby to sinter the particles together to give a conductor. The adhesiveness between the wiring formed according to the thick film paste method and the substrate may be secured by the glass frit having softened and fluidized in the baking step to wet the substrate, or by the softened and fluidized glass frit to penetrate into the sintered film of the wiring forming metal (glass bonding), or even by the inorganic oxide such as copper oxide or cadmium oxide to form a reactive oxide with the substrate (chemical bonding).

As compared with micron-size particles used in a conventional thick film paste, nano-size particles can be sintered at a low temperature and, for example, nanoparticles of silver can be sintered at 300°C or lower. When only the sintering of nanoparticles is taken into consideration, they may be baked at a temperature higher than 300°C; however, baking at a high temperature is disadvantageous in that the type of usable substrates is limited owing to the limitation on the heat resistance of substrates that are to be processed for electrode or circuit formation thereon, and in addition, it could not take advantage of the characteristic, low temperature sinterability of nanoparticles. For broadening the latitude in selecting the type of the objective substrates, the baking temperature is not higher than 300°C, preferably not higher than 250°C, more preferably not higher than 200°C, even more preferably not higher than 100°C, and is advantageously lower.

In case where the baking temperature is not higher than 300°C and is low, the glass frit, even though added according to a conventional thick film paste method, could not soften and fluidize and therefore could not wet the substrate, and as a result, there may occur a problem in that the adhesiveness to the substrate is poor. In particular, the adhesiveness to various substrates such as typically glass substrate and polyimide film substrate is poor, and therefore, it is desired to enhance the adhesiveness to glass substrate, polyimide film substrate and others.

Regarding the adhesiveness to substrate, proposed are a method comprising using a low-temperature baking gold paste that comprises gold particles having a particle size of at most 1.0 $\mu$m, a glass frit having a softening point of not higher than 450°C and an organic vehicle (Patent Reference 1); a method comprising using a noble metal paste that comprises noble metal particles having a mean particle size of from 0.01 to 0.1 $\mu$m in a resin composition and an organic solvent, or a metal soap solution (Patent Reference 2); a method comprising applying a paste that contains a metal particle dispersion of metal particles dispersed in an organic solvent and a silane coupling agent, onto a glass substrate, followed by baking it at a temperature of from 250°C to 300°C (Patent Reference 3); a method comprising using particles having a mean particle size of from 0.5 to 20 $\mu$m and particles having a mean particle size of from 1 to 100 nm as combined, and dispersing them in a thermosetting resin to secure the adhesiveness owing to the thermosetting resin (Patent Reference 4); etc.

Patent Reference 1:    JP-A 10-340619
Patent Reference 2:    JP-A 11-66957
Patent Reference 3:    JP-A 2004-179125

Patent Reference 4:     WO02/035554

PROBLEMS THAT THE INVENTION IS TO SOLVE

Hongjin Jiang et al. "Variable frequency microwave synthesis of silver nanoparticles", Journal of nanoparticles research, an interdisciplinary forum for nanoscale science and technology, Kluwer Academic Publishers, DO, Vol. 8, No.1, 17 March 2006, pages 117-124 describes a synthesis of silver nanoparticles based on a polyol process in combination with a variable frequency microwave (VFM) heating. In comparison to a conventional heating, which leads to a broader particle size distribution with a CV% value of 46%, the VFM heating allowed for a particle size distribution to be narrower with a CV% value below 40%.

Zhu Z. et al. "Synthesis and applications of hyper branched polyesters-preparation and characterization of crystalline silver nanoparticles" Materials Chemistry and Physics, Elsevier, vol. 96 no. 2-3, 10 April 2006, pages 447-453, relates to the preparation and characterization of crystalline silver nanoparticles.

Furthermore, US 6 878 184 B1 discloses a nanoparticle synthesis and the formation of inks therefrom. In one example, two separate processes are provided, including a synthesis part and an isolation of particles part. In the synthesis part, an oleic acid is used as an organic protective agent, and a triethyl amine is used as a reducing agent. In the isolation of particles part, isopropanol is added to isolate the silver particles after cooling down the reaction mixture. At the time of adding the isopropanol into the reaction mixture, the temperature thereof is at room temperature and the reaction of reducing soluble silver ions by the triethyl amine has already terminated.

In Patent Reference 1, the particle size of the gold particles is reduced to about 1/2 or less of a conventional one (to be at most 1.0 $\mu$m) and the softening point of the glass frit is made to be not higher than 450°C, whereby the glass frit can be well fixed between the glass substrate and the gold film at a baking temperature of from 500 to 600°C to thereby enhance the adhesion strength. The adhesion is owed to so-called glass bonding, and this is based on the premise that the glass frit is softened and fluidized; and therefore, the baking at a temperature not higher than the softening point of the glass frit is not taken into consideration. In addition, since an organic vehicle prepared by dissolving ethyl cellulose having a high molecular weight is added, an organic residue may remain, and it is difficult to obtain a sintered film having high adhesiveness and low electric resistance and having a smooth surface. In case where an organic substance remains, and when a dielectric layer is formed on the formed wiring or when the wiring is kept in a vacuum atmosphere, then the dielectric layer may be swollen or the vacuum atmosphere may be polluted by the peeled organic substance, thereby causing a problem of circuit reliability reduction.

In Patent Reference 2, used is a noble metal paste that comprises noble metal particles having a mean particle size of from 0.01 to 0.1 $\mu$m in a resin composition and an organic solvent, or a metal soap solution, and this is baked at 500 to 1000°C to give a smooth and dense noble metal film having a baked film thickness of from 1.5 to 3.0 $\mu$m. In this, a glass frit is not used for adhesion, and the film may secure good adhesiveness irrespective of the presence or absence of a metal soap solution. However, like in Patent Reference 1, an organic vehicle prepared by dissolving ethyl cellulose having a high molecular weight is added, the baking requires a temperature not lower than 500°C; and therefore, this has the same problems as in Patent Reference 1.

In Patent Reference 3, a paste that contains a metal particle dispersion of metal particles dispersed in an organic solvent and a silane coupling agent is applied onto a glass substrate and then baked at a temperature of from 250°C to 300°C to form thereon a thin metal film having excellent adhesiveness to the glass substrate and having a high density and a low electric resistance. According to the method, an organic vehicle with a high-molecular-weight ethyl cellulose or the like dissolved therein is not added to the ink. Accordingly, the baking does not specifically require a high temperature of not lower than 500°C, and the baking may be attained at 300°C or lower. However, since a silane coupling agent is added to the ink, it is problematic in that the ink viscosity changes with time.

In Patent Reference 4, particles having a mean particle size of from 0.5 to 20 $\mu$m and particles having a mean particle size of from 1 to 100 nm, as combined, are dispersed in a thermosetting resin, to thereby make the thermosetting resin secure the adhesiveness to substrate. Since the adhesiveness is secured by the thermosetting resin, the dispersion may be baked at 300°C or lower; however, in case where an organic substance remains, and when a dielectric layer is formed on the formed wiring or when the wiring is kept in a vacuum atmosphere, then the dielectric layer may be swollen or the vacuum atmosphere may be polluted by the peeled organic substance, thereby causing a problem of circuit reliability reduction. In addition, as containing a resin, the paste has another problem in that its viscosity is difficult to lower.

The invention is to solve these problems, and its object is to improve the adhesiveness to glass substrates, polyimide film substrates and others in low-temperature baking at 300°C or lower, in forming electrodes and circuits with a silver particle powder dispersion without adding an additive such as a silane coupling agent and an organic resin component such as a thermosetting resin to the dispersion. The silver particle powder dispersion as referred to herein includes a high-viscosity silver particle powder dispersion of so-called paste.

The invention is to solve these problems, and its object is to improve the adhesiveness to glass substrates, polyimide film substrates and others in low-temperature baking at 300°C or lower, in forming electrodes and circuits with a silver particle powder dispersion without adding an additive such as a silane coupling agent and an organic resin component such as a thermosetting resin to the dispersion. The silver particle powder dispersion as referred to herein includes a high-viscosity silver particle powder dispersion of so-called paste.

MEANS FOR SOLVING THE PROBLEMS

In accordance with the present invention, a powder of silver particles as set forth in claim 1, a dispersion of the silver particle powder as set forth in claim 4 and a method for producing a silver particle powder as set fort in claim 5 are provided. Further embodiments of the invention may inter alia be found in the dependent claims. In particular, the invention provides a powder of silver particles having an organic protective film, which has a broad particle size distribution of such that the CV% value, as computed according to the following formula (1) in which the particle diameter is determined by TEM (transmission electromicroscopy), is at least 50%. The mean particle diameter $D_{TEM}$ is, for example, at most 200 nm. The organic protective film comprises, for example, a fatty acid (oleic acid, etc.) having a molecular weight of from 100 to 1000 and an amine compound having a molecular weight of from 100 to 1000, and at least any one of the fatty acid and the amine compound has at least one unsaturated bond in one molecule.

$$CV\% = 100 \text{ x [standard deviation of particle diameter, } \sigma_D] \text{ / [mean particle diameter,}$$

$$D_{TEM}] \ \dots \ (1)$$

The mean particle diameter $D_{TEM}$, as determined by TEM, is computed as follows: On a 600,000-power enlarged TEM image, 300 independent particles not overlapping with each other are analyzed to determine their diameter, and the data are averaged. For the particle diameter of each particle, employed is the largest diameter (major diameter) measured on the image.

The invention also provides a dispersion of said silver particle powder produced by dispersing said silver particle powder in a non-polar or poorly-polar liquid organic medium having a boiling point of from 60 to 300°C. The dispersion is applied onto a substrate to form a coating film thereon, and thereafter the coating film is baked to realize a baked silver film having good adhesiveness to the substrate. The baking may be attained in an oxidizing atmosphere at a temperature not higher than 300°C and falling within a range within which silver is sintered.

For producing said silver particle powder, herein provided is a production method comprising reducing a silver compound in the presence of an organic protective agent in an alcohol or a polyol, using the alcohol or the polyol as a reducing agent, to thereby precipitate silver particles, wherein a fatty acid having a molecular weight of from 100 to 1000 and an amine compound having a molecular weight of from 100 to 1000 are used as the organic protective agent and at least any one of the fatty acid and the amine compound has at least one unsaturated bond in one molecule. As the fatty acid, preferred is oleic acid. Preferably, at least any one of a secondary amine and a tertiary amine is made to be present in the reduction system, as a reduction promoter.

The silver particle powder of the invention has a broad particle size distribution, and therefore, it may be presumed that, when the dispersion is applied onto a substrate, then smaller particles may gather around the interface with the substrate and the particle density in the interface may increase with the result that, even in low-temperature baking at 300°C or lower, the coating film may ensure good adhesiveness to glass substrate, polyimide film substrates, etc. In addition, since the powder does not contain a silane coupling agent, it may provide an ink free from a problem of time-dependent change; and as not containing a thermosetting resin, the powder may provide an ink having a low viscosity.

PREFERRED EMBODIMENTS OF THE INVENTION

Heretofore the present inventors have repeatedly made experiments for producing a silver particle powder in a liquid-phase process, and have developed a method for producing a silver particle powder which comprises reducing silver nitrate in an alcohol having a boiling point of from 85 to 150°C, at a temperature of from 85 to 150°C in the presence of an organic protective agent comprising, for example, an amine compound having a molecular weight of from 100 to 400. The inventors have also developed a method for producing a silver particle powder, which comprises reducing a silver compound (typically silver carbonate or silver oxide) in an alcohol or a polyol having a boiling point of not lower than 85°C, at a temperature not lower than 85°C in the presence of an organic protective agent comprising, for example, a fatty acid having a molecular weight of from 100 to 400. According to these methods, a powder of silver nanoparticles having extremely good dispersibility can be obtained.

However, when the silver particle powder dispersion obtained according to these methods is applied onto a substrate to form a coating film thereon and thereafter the coating film is baked to give a baked silver film, then it has been found that the adhesiveness of the film to the substrate is not always sufficient. As a result of detailed investigations made thereafter, it has been considered that the reason would be because the particle size distribution of the silver particle powder is too sharp and the particle size is too much unified.

The inventors have further studied and, as a result, have confirmed that, in producing silver particles according to the above-mentioned reduction, when "fatty acid" and "amine compound", as combined, are added thereto as an organic protective agent, then the silver particles produced may have a broad particle size distribution, and the baked silver film formed by the use of the silver particle powder as a filler may have noticeably enhanced adhesiveness to the substrate. However, at least any one of the fatty acid and the amine compound has at least one unsaturated bond.

The matters specific to the invention are described below.

[Mean Particle Diameter $D_{TEM}$]

The mean particle diameter $D_{TEM}$, as determined through TEM, of the silver particle powder of the invention is preferably at most 200 nm, more preferably at most 100 nm, even more preferably at most 50 nm, still more preferably at most 30 nm. For use for inkjet, it is preferably at most 20 nm. Not specifically defined, the lowermost limit of the mean particle diameter $D_{TEM}$ may be, for example, at least 3 nm. In producing the silver particle powder of the invention, the mean particle diameter $D_{TEM}$ thereof may be controlled by controlling the molar ratio of alcohol or polyol/Ag, the molar ratio of organic protective agent/Ag, the molar ratio of reduction promoter/Ag, the heating speed in reduction, the stirring power, the type of the silver compound, the type of the alcohol or polyol, the type of the reduction promoter, the type of the organic protective agent, etc.

[CV% Value]

The silver particle powder of the invention is characterized by having a broad particle size distribution. Concretely, the powder has a particle size distribution of such that the CV% value, as computed according to the following formula (1), is at least 50 %:

$$CV\% = 100 \text{ x [standard deviation of particle diameter, } \sigma_D] \text{ / [mean particle diameter, } D_{TEM}] \dots (1)$$

For the particle diameter of each particle for computing the standard deviation $\sigma_D$, employed is the particle diameter of each particle measured in determining the mean particle diameter $D_{TEM}$. The CV% value may be controlled by the molar ratio of organic protective agent/Ag, the type of the organic protective agent, etc.

When a dispersion prepared by dispersing the silver particle powder having such a broad particle size distribution in a liquid organic medium is used, the baked silver film formed by baking it at a low temperature of not higher than 300°C may have noticeably enhanced adhesiveness to the substrate even though an adhesiveness-enhancing means such as a silane coupling agent, a thermosetting resin or the like is not used along with it. Though the mechanism is not clarified at present, it may be presumed that various particles having a different particle size are mixed and fine particles may fill the voids formed by large particles deposited on the interface of the substrate, whereby the filling density of the particles around the interface may increase and the contact area between the baked silver film and the substrate may increase. The CV% value must be at least 50 %.

[Alcohol or Polyol]

In the invention, a silver compound is reduced in a liquid of one or more alcohols or polyols. The alcohol or polyol functions as a medium and a reducing agent. The alcohol includes propyl alcohol, n-butanol, isobutanol, sec-butyl alcohol, hexyl alcohol, heptyl alcohol, octyl alcohol, allyl alcohol, crotyl alcohol, cyclopentanol, etc. The polyol includes diethylene glycol, triethylene glycol, tetraethylene glycol, etc. Above all, preferred are isobutanol and n-butanol.

[Organic Protective Film and Organic Protective Agent]

The silver particles to constitute the silver particle powder of the invention are coated with an organic protective film on their surfaces. The protective film is formed by making an organic protective agent present in the reduction in alcohol or polyol. In the invention, "fatty acid" and "amine compound" are used as the organic protective agent. At least one of both is composed of a substance having at least one unsaturated bond. The unsaturated bond makes it possible to produce a silver nanoparticle powder having excellent low-temperature sinterability.

Both the fatty acid and the amine compound have a molecular weight of from 100 to 1000. Those having a molecular weight of less than 100 could not sufficiently attain the effect of inhibiting particle aggregation. On the other hand, when the molecular weight thereof is too large, the substances could have a high aggregation inhibiting power, but the intergranular sintering in applying and baking the silver particle powder dispersion may be inhibited whereby the electric resistance of the wiring may increase and, as the case may be, the wiring could not have electric conductivity. Accordingly, both the fatty acid and the amine compound must have a molecular weight of at most 1000. More preferred are those having a molecular weight of from 100 to 400.

Typical fatty acids for use in the invention include, for example, oleic acid, linolic acid, linolenic acid, palmitoleic acid, myristoleic acid. These may be used either singly or as combined. The amine compound is preferably a primary amine. Typical amine compounds for use in the invention include, for example, hexanolamine, hexylamine, 2-ethylhexylamine, dodecylamine, octylamine, laurylamine, tetradecylamine, hexadecylamine, oleylamine, octadecylamine. Also these may be used either singly or as combined.

[Silver Compound]

For the source of silver, usable are silver compounds such as various silver salts and silver oxides. For example, they include silver chloride, silver nitrate, silver oxide, silver carbonate, etc.; and silver nitrate is preferred for industrial use.

[Reduction Promoter]

In promoting the reduction, a reduction promoter is preferably used. For the reduction promoter, usable is an amine compound having a molecular weight of from 100 to 1000. Of such amine compounds, preferred are secondary or tertiary amine compounds having a strong reducing power. Like the organic protective agent, the reduction promoter having a molecular weight of less than 100 may be poorly effective for inhibiting particle aggregation, while that having a molecular weight of more than 1000 may be effective for aggregation inhibition but may interfere with the intergranular sintering in applying and baking the silver particle powder dispersion, whereby the electric resistance of the wiring may increase and, as the case may be, the wiring could not have electric conductivity; and therefore, these are unsuitable. Typical amine compounds usable in the invention include, for example, diisopropylamine, diethanolamine, diphenylamine, dioctylamine, triethylamine, triethanolamine, N,N-dibutylethanolamine. In particular, diethanolamine and triethanolamine are preferred.

[Liquid Organic Medium]

For producing a dispersion of the silver particle powder, as prepared through reduction, a non-polar or poorly-polar liquid organic medium having a boiling point of from 60 to 300°C is used in the invention. "Non-polar or poorly-polar" as referred to herein means that the relative dielectric constant at 25°C of the medium is at most 15, more preferably at most 5. In case where the relative dielectric constant of the medium is more than 15, the dispersibility of silver particles may worsen and they may settle, which is unfavorable. Depending on the use of the dispersion, various liquid organic media may be used, and hydrocarbons are preferred. In particular, herein usable are aliphatic hydrocarbons such as isooctane, n-decane, isododecane, isohexane, n-undecane, n-tetradecane, n-dodecane, tridecane, hexane, heptane; aromatic hydrocarbons such as benzene, toluene, xylene, ethylbenzene, decalin, tetralin; etc. One or more of these liquid organic media may be used. A mixture such as kerosene is also usable. Further, a polar organic medium of alcohols, ketones, ethers, esters and the like may be added to the liquid organic medium for controlling the polarity of the resulting mixture, within a range within which the specific dielectric constant at 25°C of the mixture could be at most 15.

[Production of Silver Particle Powder]

Next described is a method for producing the silver particle powder of the invention.

The silver particle powder of the invention may be produced by reducing a silver compound in an alcohol or polyol in the presence of an organic protective agent. As so mentioned in the above, "fatty acid" and "amine compound" are used as the organic protective agent, and the blend ratio of the two may be, for example, within a range of [fatty acid] / [amine compound] by mol of from 0.001/1 to 0.01/1, more preferably from 0.005/1 to 0.01/1. The Ag ion concentration in the liquid may be at least 50 mmol/L, for example, from 50 to 500 mmol/L or so.

The reduction may be attained under heat at 80 to 200°C, preferably at 85 to 150°C. Preferably, the reduction is attained under a reflux condition under which vaporization and condensation of alcohol or polyol serving both as a medium and as a reducing agent, are repeated. For efficiently conducting the reduction, the above-mentioned reduction promoter is preferably used. As a result of various investigations, the reduction promoter is preferably added nearly at the end of the reduction, and the amount of the reduction promoter to be added is preferably within a range of from 0.1 to 20 in terms of the ratio by mol to Ag.

After the reaction, the silver nanoparticle suspension (slurry just after the reaction) is, for example, processed in steps of washing, dispersing, classifying and the like according to the process shown in Examples to be given hereinunder, thereby producing a dispersion of the silver particle powder of the invention.

[Use of Silver Particle Powder of the Invention]

The silver particle powder of the invention is favorable for a wiring forming material for forming circuit micropatterns, for example, a wiring forming material according to an inkjet method, for a film forming material substitutive for film formation by sputtering in a vacuum film formation process, for a film forming material substitutive for film formation by plating in a wet process, etc. The silver particle powder of the invention is also favorable for a wiring forming material for wiring on LSI substrates, for electrodes and wirings for FPDs (flat panel displays), and further for burying micro-size trenches, via holes, contact holes, etc. As capable of being baked at a low temperature, the powder is also applicable to an electrode forming material on a flexible film, and in electronics packaging, the powder may be used as a bonding material. The powder is also applicable to an electromagnetic wave shield film as a conductive film, to an IR reflection shield taking advantage of the optical characteristics of the powder in the field of transparent conductive films, etc. As having low-temperature sinterability and electroconductivity, the powder may be printed on a glass substrate and baked thereon to give antifogging heating wires for windshields for automobiles, etc. On the other hand, the dispersion is applicable not only to an inkjet method but also to other various coating methods of spin coating, dipping, blade coating or the like, and further to screen printing, etc.

[Baking]

The dispersion of the silver particle powder of the invention is applied onto a substrate, and then baked to give a baked silver film. The baking is attained in an oxidizing atmosphere. The oxidizing atmosphere as referred to herein is a non-reducing atmosphere, therefore including a normal-pressure atmospheric environment, a reduced-pressure atmosphere, and an inert gas atmosphere with minor oxygen introduced thereinto. The baking temperature may be from 100 to 300°C, and may be a low temperature. However, depending on the mean particle diameter $D_{TEM}$ and the condition of the coating film, the lowermost limit of the temperature at which silver may be sintered varies in some degree. In case where the coating film is not sintered at 100°C, it may be baked at a temperature falling within a range of from the lowermost temperature at which it is sintered to 300°C.

Not specifically defined, the baking apparatus may be any one capable of realizing the above-mentioned atmosphere and temperature. For example, it includes a hot air circulating drier, a belt-type baking furnace, an IR baking furnace, etc. In case where wirings or electrodes are formed on a film substrate (e.g., polyimide film substrate), not a batch-type apparatus but a continuous baking apparatus applicable to a roll-to-roll system for mass-production is preferred in view of the producibility thereof. Regarding the baking time, preferably, the substrate having the coating film formed thereon is kept within the above-mentioned temperature range for at least 10 minutes, more preferably for at least 60 minutes.

EXAMPLES

[Example 1]

0. 6 g of oleic acid, a fatty acid, and 110 g of oleylamine, a primary amine compound, both serving as an organic protective agent, and 14 g of silver nitrate crystal, a silver compound, were added to 64 g of isobutanol, a medium also serving as a reducing agent, and stirred with a magnetic stirrer to dissolve the silver nitrate. The solution was transferred into a container equipped with a refluxing condenser, and set in an oil bath. With introducing nitrogen gas, an inert gas, at a flow rate of 400 mL/min into the container and with stirring the liquid with a magnetic stirrer at a rotational speed of 100 rpm, this was heated and kept heated under reflux at a temperature of 108°C for 6 hours. 5 hours after the system had reached 108°C, 26 g of diethanolamine, a reduction promoter was added. In this stage, the heating speed up to 108°C was 2°C/min.

After the reaction, the slurry was washed, dispersed and classified according to the process mentioned below.

[Washing Step]

[1] 40 mL of the slurry after the reaction is subjected to solid-liquid separation at 3000 rpm for 30 minutes, using a centrifuge (Hitachi Koki's CF7D2), and the supernatant is removed.

[2] 40 mL of methanol having large polarity is added to the precipitate, which is then dispersed with an ultrasonic disperser.

[3] The above-mentioned steps [1] to [2] are repeated three times.

[4] The dispersion is processed according to the above-mentioned step [1], the supernatant is removed, and the precipitate is collected.

[Dispersion Step]

[1] 40 mL of tetradecane having small polarity is added to the precipitate after the above-mentioned washing step.

[2] Next, this is processed with an ultrasonic disperser.

[Classification Step]

[1] A mixture of the silver and 40 mL of tetradecane particles after the dispersion step is processed for solid-liquid separation, using the same centrifuge as above at 3000 rpm for 30 minutes.

[2] The supernatant is collected. The supernatant is a silver particle powder dispersion.

The silver particles in the dispersion were analyzed through TEM. As in the above, the particle diameter of 300 particles on a 600,000-power image was measured. As a result, the mean particle diameter $D_{TEM}$ was 5.2 nm, and the CV% value was 55.4 %.

Next, the silver particle dispersion produced according to the above process was applied onto a glass substrate according to a spin coating method to form a coating film, then left at room temperature for 5 minutes, and the glass substrate having the coating film was put on a hot plate conditioned at 200°C, and then kept as such for 60 minutes to bake the film to give a baked silver film.

Thus obtained, the baked silver film was analyzed for the adhesiveness to the substrate and the volume resistivity according to the methods mentioned below.

[Adhesiveness Test]

Using a cutter, the baked silver film was cut to form 100 cross-cuts of 1 mm square each, and an adhesive cellophane tape having an adhesion powder of about 8 N per width of 25 mm (JIS Z1522) was stuck to it under pressure, and then peeled. The number of the remaining cross-cuts was counted. The sample in which all the 100 cross-cuts remained was the best in point of the adhesiveness thereof, and was expressed as 100/100; and the sample in which all the 100 cross-cuts peeled away was the worst in point of the adhesiveness thereof, and was expressed as 0/100. According to the adhesiveness evaluation test made in that manner, the adhesiveness of the baked silver film in this Example was expressed as 100/100 and was good.

[Volume Resistivity]

From the surface resistance measured with a surface resistivity meter (Mitsubishi Chemical's Loresta HP), and the film thickness measured with a fluorescent X-ray film thickness meter (SII's SFT9200), the volume resistivity was determined by computation. As a result, the thickness of the baked silver film of this Example was 0.51 $\mu$m, and the volume resistivity thereof was 17.5 $\mu\Omega\cdot$cm.

[Example 2]

An experiment was carried out under the same condition as in Example 1, in which, however, the amount of oleic acid added was increased from 0.6 g to 1.2 g.

As a result, the mean particle diameter, $D_{TEM}$ of the silver particle powder produced in this Example was 5.2 nm, and the CV% value thereof was 50.6 %.

Thus formed, the baked silver film was tested in the above-mentioned adhesiveness test, and as a result, the adhesiveness to glass substrate of the baked silver film obtained in this Example was 100/100, and was good like in Example 1.

The thickness of the baked silver film of this Example was 0.54 $\mu$m, and the volume resistivity thereof was 18.0

$\mu\Omega\cdot$cm; and the volume resistivity of the film was also good, like in Example 1.

[Comparative Example 1]

In Example 1, oleic acid was not added and 110 g of oleylamine alone was used as the organic protective agent. In this experiment, the other condition was the same as in Example 1.
As a result, the mean particle diameter, $D_{TEM}$ of the silver particle powder produced in this Comparative Example was 8.2 nm and the CV% value thereof was 12.5%; and the powder could not realize the broad particle size distribution like that in Examples 1 and 2.
The thickness of the baked silver film produced in this Comparative Example was 0.53 $\mu$m and the volume resistivity thereof was 2.4 $\mu\Omega\cdot$cm; and the volume resistivity of the film was good. However, as a result of the above-mentioned adhesiveness test, the adhesiveness to the glass substrate of the baked silver film produced in this Comparative Example was 0/100 according to the above-mentioned adhesiveness evaluation method, and the adhesiveness of the film was poor.

**Claims**

1. A powder of silver particles having an organic protective film, which has a broad particle size distribution of such that the CV% value, as computed according to the following formula (1) in which the particle diameter is determined by TEM, is at least 50 %:

```
CV% = 100 X [standard deviation of particle diameter, σD]/[mean

particle diameter, DTEM] … (1).
```

2. The silver particle powder as claimed in claim 1, wherein the mean particle diameter $D_{TEM}$ is at most 200 nm.

3. The silver particle powder as claimed in claim 1 or 2, wherein the organic protective film comprises a fatty acid having a molecular weight of from 100 to 1000 and an amine compound having a molecular weight of from 100 to 1000, and at least any one of the fatty acid and the amine compound has at least one unsaturated bond in one molecule.

4. A dispersion of the silver particle powder produced by dispersing the silver particle powder of any one of claims 1 to 3 in a non-polar or poorly-polar liquid organic medium having a boiling point of from 60 to 300°C.

5. A method for producing the silver particle powder of any of claims 1 to 3, which comprises reducing a silver compound in the presence of an organic protective agent in an alcohol or a polyol, using the alcohol or the polyol as a reducing agent, to thereby precipitate silver particles, and wherein a fatty acid having a molecular weight of from 100 to 1000 and an amine compound having a molecular weight of from 100 to 1000 are used as the organic protective agent and at least any one of the fatty acid and the amine compound has at least one unsaturated bond in one molecule.

6. The method for producing the silver particle powder as claimed in claim 5, wherein the fatty acid is oleic acid.

7. The method for producing the silver particle powder as claimed in claim 5 or 6, wherein at least any one of a secondary amine and a tertiary amine is made to be present in the reduction system, as a reduction promoter.

**Patentansprüche**

1. Pulver aus Silberpartikeln mit einem organischem Schutzfilm, welches eine breite Partikelgrößenverteilung hat, sodass der CV%-Wert, wie gemäß der folgenden Formel (1) berechnet, wobei der Partikeldurchmesser durch Transmissionselektronenmikroskopie bestimmt wird, mindestens 50% ist:

$$CV\% = 100x\ [\text{Standartabweichung des Partikeldurchmessers, } \sigma_D]\ /\ [\text{mittlerer Partikeldurchmesser, } D_{TEM}]...(1).$$

**2.** Silberpartikelpulver nach Anspruch 1, wobei der mittlere Partikeldurchmesser $D_{TEM}$ höchstens 200 nm ist.

**3.** Silberpartikelpulver nach Anspruch 1 oder 2, wobei der organische Schutzfilm eine Fettsäure mit einem Molekulargewicht von 100 bis 1000 und eine Aminverbindung mit einem Molekulargewicht von 100 bis 1000 aufweist, und wobei die Fettsäure und/oder die Aminverbindung zumindest eine ungesättigte Bindung in einem Molekül hat/haben.

**4.** Dispersion des Silberpartikelpulvers, welche durch Dispergieren des Silberpartikelpulvers nach einem der Ansprüche 1-3 in einem nicht polaren oder wenig polaren flüssigen organischen Medium mit einem Siedepunkt von 60 bis 300°C erzeugt wird.

**5.** Verfahren zum Erzeugen des Silberpartikelpulvers nach einem der Ansprüche 1-3, welches aufweist, eine Silberverbindung in Anwesenheit eines organischen Schutzmittels in einem Alkohol oder Polyol zu reduzieren, wobei der Alkohol oder das Polyol als Reduzierungsmittel verwendet wird, um dadurch Silberpartikel auszufällen, und wobei eine Fettsäure mit einem Molekulargewicht von 100 bis 1000 und eine Aminverbindung mit einem Molekulargewicht von 100 bis 1000 als des organische Schutzmittel verwendet werden, und wobei die Fettsäure und/oder die Aminverbindung mindestens eine ungesättigte Bindung in einem Molekül hat/haben.

**6.** Verfahren zum Erzeugen des Silberpartikelpulvers nach Anspruch 5, wobei die Fettsäure Oleinsäure ist.

**7.** Verfahren zum Erzeugen des Silberpartikelpulvers nach Anspruch 5 oder 6, wobei ein sekundäres Amin und/oder ein tertiäres Amin in dem Reduktionssystem als ein Reduktionspromotor eingebracht wird.

## Revendications

**1.** Poudre de particules d'argent comportant un film de protection organique, qui a une large distribution de tailles de particules telle que la valeur CV%, calculée selon la formule (1)suivante dans laquelle le diamètre de particule est déterminé par TEM, est d'au moins 50%:

$$CV\% = 100\ X\ [\text{écart type du diamètre de particule, } \sigma_D]/[\text{diamètre moyen de particule, } D_{TEM}]\ ...(1).$$

**2.** Poudre de particules d'argent selon la revendication 1, dans laquelle le diamètre moyen de particule est au plus de 200 nm.

**3.** Poudre de particules d'argent selon la revendication 1 ou 2, dans laquelle le film de protection organique comprend un acide gras ayant un poids moléculaire compris entre 100 et 1000 et un composé aminé ayant un poids moléculaire compris entre 100 et 1000, et dans laquelle au moins l'un de l'acide gras et du composé aminé a au moins une liaison non saturée dans une molécule.

**4.** Dispersion de poudre de particules d'argent fabriquée en dispersant la poudre de particules d'argent de l'une quelconque des revendications 1 à 3 dans un milieu organique liquide non polaire ou faiblement polaire ayant un point d'ébullition compris entre 60 et 300°C.

**5.** Procédé de fabrication de la poudre de particules d'argent selon l'une quelconque des revendications 1 à 3, comprenant la réduction d'un composé d'argent en présence d'un agent de protection organique dans un alcool ou un polyol, en utilisant l'alcool ou le polyol comme agent réducteur, pour précipiter ainsi des particules d'argent, et dans lequel un acide gras ayant un poids moléculaire compris entre 100 et 1000 et un composé aminé ayant un poids moléculaire compris entre 100 et 1000 sont utilisés comme agent de protection organique et au moins l'un de l'acide gras et du composé aminé comporte au moins une liaison non saturée dans une molécule.

**6.** Procédé de fabrication de la poudre de particules d'argent selon la revendication 5, dans lequel l'acide gras est de l'acide oléique.

7. Procédé de fabrication de la poudre de particules d'argent selon la revendication 5 ou 6, dans lequel au moins l'une d'une amine secondaire et d'une amine tertiaire est apportée dans le système de réduction, comme promoteur de réduction.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 10340619 A
- JP 11066957 A
- JP 2004179125 A
- WO 02035554 A
- US 6878184 B1

### Non-patent literature cited in the description

- Variable frequency microwave synthesis of silver nanoparticles. **HONGJIN JIANG et al.** Journal of nanoparticles research, an interdisciplinary forum for nanoscale science and technology. Kluwer Academic Publishers, 17 March 2006, vol. 8, 117-124
- Synthesis and applications of hyper branched polyesters-preparation and characterization of crystalline silver nanoparticles. **ZHU Z. et al.** Materials Chemistry and Physics. Elsevier, 10 April 2006, vol. 96, 447-453